# EUROPÄISCHE PATENTSCHRIFT

(11) **EP 3 620 804 B1**
(45) Veröffentlichungstag und Bekanntmachung des Hinweises auf die Patenterteilung: **14.05.2025**
(21) Anmeldenummer: 19196213.3
(22) Anmeldetag: 09.09.2019
(51) Int. Cl.: G01R 31/69

(54) **PRÜFVORRICHTUNG FÜR DIE ELEKTRIK EINES LKW MIT EINEM STECKER ZUM EINSTECKEN IN EINE ANHÄNGERSTECKDOSE DES LKW**
TEST DEVICE FOR THE ELECTRICAL SYSTEM OF A TRUCK, COMPRISING A PLUG FOR INSERTING INTO A TRAILER SOCKET OF THE TRUCK
DISPOSITIF DE VÉRIFICATION DE L'ÉQUIPEMENT ÉLECTRIQUE D'UN POIDS LOURD DOTÉ D'UNE FICHE À ENFICHER DANS UNE PRISE DE COURANT DE REMORQUE DU POIDS LOURD

(30) Priorität: 07.09.2018 DE 202018105117 U
(43) Veröffentlichungstag der Anmeldung: 11.03.2020
(73) Patentinhaber: Rüttgerodt, Werner, 34355 Staufenberg (DE)
(72) Erfinder: Rüttgerodt, Werner, 34355 Staufenberg (DE)
(74) Vertreter: REHBERG HÜPPE + PARTNER

(56) Entgegenhaltungen:
- AU-B2- 2007 200 862
- DE-A1- 102013 103 307
- DE-A1- 19 912 732
- US-A- 4 249 125
- US-A- 5 936 407
- US-A1- 2007 152 502
- US-A1- 2015 137 961
- US-B1- 6 259 170
- PHILLIPS: "QwikTechTips_June11 Troubleshooting Trailer Lights", 27 June 2011 (2011-06-27), XP055659309, Retrieved from the Internet <URL:http://www.phillipsqwiktechtips.com/QwikTechTips_June11.pdf>
- KUNZER: "7TT13 Handprüfgerät für 13-polige Stecker und Steckdosen", 3 May 2017 (2017-05-03), XP055658967, Retrieved from the Internet <URL:http://wakat.wm-werkstattausruestung.de/catalog/category/list/id/211202/browseMode/dataset/pId/464585/page/33>
- KUNZER: "PRODUKTINFO Handprüfgerät zum Testen von 13-poligen Steckern und Steckdosen", 31 January 2017 (2017-01-31), XP055658952, Retrieved from the Internet <URL:http://downloads.cdn.re-in.de/1500000-1599999/001534216-in-01-de-PRUEFGERAET_13_POL_STECKERN_UND_STECKDOS.pdf>
- WIKIPEDIA: "Anhängersteckdose", 17 June 2018 (2018-06-17), XP055659283, Retrieved from the Internet <URL:https://de.wikipedia.org/w/index.php?title=Anh%C3%A4ngersteckdose&oldid=178385373>

## Beschreibung

### TECHNISCHES GEBIET DER ERFINDUNG

Die Erfindung bezieht sich auf eine Prüfvorrichtung für die Elektrik eines LKW. Genauer bezieht sich die Erfindung auf eine solche Prüfvorrichtung, mit der ein korrekter Anschluss und eine korrekte Funktion einer Anhängersteckdose des LKW und von daran angeschlossenen Teilen der Elektrik des LKW überprüfbar sind. Dazu weist die Prüfvorrichtung einen Stecker zum Einstecken in die Anhängersteckdose des LKW, der Steckerkontakte zum Kontaktieren von Dosenkontakten der Anhängersteckdose umfasst, und ein Gehäuse auf, in dem der Stecker befestigt ist, in dem eine Prüfeinrichtung gelagert ist und an dem mindestens ein optischer Signalgeber angeordnet ist. Die Prüfeinrichtung ist an die Steckerkontakte und den mindestens einen Signalgeber angeschlossen und steuert den mindestens einen Signalgeber in Abhängigkeit von elektrischen Spannungen zwischen den Steckerkontakten an.

### STAND DER TECHNIK

Eine Prüfvorrichtung, mit der ein korrekter Anschluss und eine korrekte Funktion einer Anhängersteckdose des LKW und von daran angeschlossenen Teilen der Elektrik des LKW überprüfbar sind, ist als ABS-Prüfstecker der Secorüt Kfz-Electronic GmbH, Staufenberg, Deutschland bekannt, siehe https://www.secoruet.net/secoruet_produkt/abs-prufstecker/. Hier ist an dem dem Stecker abgekehrten Ende des Gehäuses ein Signalgeber in Form einer Kontrollleuchte angeordnet, die leuchtet, wenn der ABS-Prüfstecker in eine Anhängersteckdose nach der Norm ISO 7638 eingesteckt wird und zwischen den Polen 1 und 3 sowie den Polen 2 und 4 dieser Anhängersteckdose eine Versorgungsspannung und an dem Pol 5 eine Signalspannung anliegt.

Der bekannte ABS-Prüfstecker lässt nicht erkennen, welcher der Dosenkontakte der mit ihm überprüften Anhängersteckdose falsch belegt ist. Er lässt auch keine Prüfung eines an die Anhängersteckdose angeschlossenen Anhängers zu. Zudem lässt die Prüfung nicht erkennen, ob die Elektrik des jeweiligen LKW Mängel aufweist, wenn die jeweilige Anhängersteckdose grundsätzlich richtig angeschlossen ist und irgendwelche Versorgungs- und Signalspannungen an ihren Dosenkontakten anliegen.

Aus der DE 44 92 205 T1 ist ein Anhängerbeleuchtungs-Prüfgerät für einen Anhänger bekannt, das Anzeigeleuchten in zugehörigen Anhänger-Stromkreisen aufweist, welche mittels einer Steckverbindung mit hinzugehörigen Stromkreisen einer Zugmaschine lösbar zu verbinden sind. Das Prüfgerät weist eine Energiequelle, eine Prüflampe und einen in einem Prüfkreis angeordneten Schalter auf, mittels dessen der Prüfkreis über mindestens eine Anzeigeleuchte des Anhängers geschlossen und die Prüflampe aktiviert wird, wenn die Anzeigeleuchte des Anhängers und der zugehörige Anhänger-Stromkreis Strom erhalten. Dabei ist für jeden Anhänger-Stromkreis ein separater Prüfkreis vorgesehen und in jedem Prüfkreis eine separate Anzeigeleuchte angeordnet. Jeder Prüfkreis weist zudem eine Diode auf, die den Prüfkreis bei Stromzufuhr von der Energiequelle von anderen Prüfkreisen trennt.

Aus der DE 199 12 732 A1 ist ein Prüfgerät für eine Anhängersteckdose mit einer Prüfschaltung, mit Leuchtmitteln und mit den Merkmalen des Oberbegriffs des unabhängigen Patentanspruchs 1 bekannt. Die Prüfschaltung nimmt eine Simulation der Glühlampenwiderstände des Beleuchtungs- und Bremssystems vor, und sie umfasst eine Speicher- und- Reset-Funktion. Bei der Prüfschaltung liegen zwei Widerstände in Reihe, wobei einer der Widerstände variabel einstellbar ist. An die Mitte der Widerstände ist die Basis eines Transistors angeschlossen, und in dem Kollektorpfad des Transistors liegt das Leuchtmittel. Parallel zu dem variablen Widerstand ist ein Kondensator angeordnet. Durch den variablen Widerstand ist es möglich, unterschiedliche Glühlampenwiderstände zu simulieren. Indem die Simulation des Glühlampenwiderstands vorgenommen wird, leuchtet zusätzlich zu dem jeweiligen Leuchtmittel des Prüfgeräts das entsprechende Leuchtmittel im Kontrollfeld der Fahrerkabine des jeweiligen Kraftfahrzeugs auf, das dem Fahrer anzeigt, dass er die zugehörige Beleuchtung eingeschaltet hat.

Eine weitere Prüfvorrichtung mit den Merkmalen des Oberbegriffs des unabhängigen Patentanspruchs 1 ist aus der US 4 249 125 A bekannt. Hier ist zwischen jedem Steckerkontakt des Steckers der Prüfvorrichtung und einem über einen anderen Steckerkontakt übermitteltes Bezugspotential eine Leuchtdiode mit einem Vorwiderstand in Reihe geschaltet. Die Leuchtdiode leuchtet dann, wenn an dem jeweiligen Steckerkontakt eine so hohe Spannung anliegt, dass die Durchlassspannung der Leuchtdiode überschritten wird.

Aus der AU 2007 200 862 B2 ist ebenfalls eine Prüfvorrichtung mit dem Merkmal des Oberbegriffs des unabhängigen Patentanspruchs 1 bekannt, bei der zwischen dem jeweiligen Steckerkontakt und das über einen anderen Steckerkontakt übermittelte Bezugspotential eine Leuchtdiode mit einem Vorwiderstand in Reihe geschaltet ist.

Aus Phillips: "QwikTechTips_June11 Troubleshooting Trailer Lights", 27. Juni 2011 (2011-06-27), XP055659309, ist eine Prüfvorrichtung für die Elektrik eines LKW mit einem Stecker zum Einstecken in eine Anhängersteckdose des LKW und mit LED als Signalgebern bekannt, die nur dann aufleuchten, wenn eine Betätigung der entsprechenden Beleuchtung des LKW erfolgt und die Anhängersteckdose richtig angeschlossen ist. Für den Fall, dass eine LED der Prüfvorrichtung beim Aktivieren der entsprechenden Beleuchtung des LKW nicht aufleuchtet, wird vorgeschlagen, eine Spannung des entsprechenden Schutzschalters an der Anhängersteckdose des LKW zu messen.

Aus der US 6 259 170 B1 ist eine Prüfvorrichtung bekannt, die zwischen eine Anhängersteckdose eines Zugfahrzeugs und einen Anhängersteckers eines Anhängers steckbar ist. Die Prüfvorrichtung weist je Steckerkontakt der Anhängersteckdose zwei LED auf, die so verschaltet sind, dass die eine LED einen Stromfluss über den Steckerkontakt anzeigt, während die anderen LED anzeigt, dass ein zwischen der Anhängersteckdose und dem Anhängerstecker angeordnetes strombegrenztes Element den über den Steckerkontakt fließenden Strom begrenzt.

### AUFGABE DER ERFINDUNG

Der Erfindung liegt die Aufgabe zugrunde, eine Prüfvorrichtung für die Elektrik eines LKW mit den Merkmalen des Oberbegriffs des unabhängigen Patentanspruchs 1 aufzuzeigen, mit der mit weiterhin geringem Aufwand eine eingehendere Diagnose der Elektrik des jeweiligen LKW durchführbar ist.

### LÖSUNG

Die Aufgabe der Erfindung wird durch eine Prüfvorrichtung mit den Merkmalen des unabhängigen Patentanspruchs 1 gelöst. Die abhängigen Patentansprüche 2 bis 12 betreffen bevorzugte Ausführungsformen der erfindungsgemäßen Prüfvorrichtung. Der Patentanspruch 13 ist auf eine spezielle Verwendung der erfindungsgemäßen Prüfvorrichtung gerichtet.

### BESCHREIBUNG DER ERFINDUNG

Bei einer erfindungsgemäßen Prüfvorrichtung für die Elektrik eines LKW mit einem Stecker zum Einstecken in eine Anhängersteckdose des LKW, der Steckerkontakte zum Kontaktieren von Dosenkontakten der Anhängersteckdose umfasst, und einem Gehäuse, an dem der Stecker befestigt ist, in dem eine Prüfeinrichtung gelagert ist und an dem mindestens ein optischer Signalgeber angeordnet ist, wobei die Prüfeinrichtung an die Steckerkontakte und dem mindestens einen Signalgeber angeschlossen ist und den mindestens einen Signalgeber in Abhängigkeit von elektrischen Spannungen zwischen den Steckerkontakten ansteuert, steuert die Prüfeinrichtung den mindestens einen Signalgeber sowohl abhängig davon an, ob an mindestens einem der Steckerkontakte irgendeine elektrische Spannung gegenüber einem Bezugspotential, die das richtige Vorzeichen aufweist, anliegt oder nicht, als auch abhängig davon, ob die Spannung zwischen dem mindestens einen der Steckerkontakte und einem Bezugspotential einen vorgegebenen Mindestwert erreicht oder nicht.

Die Prüfeinrichtung der erfindungsgemäßen Prüfvorrichtung überprüft mindestens einen der Steckerkontakte also nicht nur darauf, ob hieran eine Spannung richtigen Vorzeichens gegenüber einem Bezugspotential anliegt, sondern sie überprüft auch die Höhe dieser Spannung, indem sie sie mit dem vorgegebenen Mindestwert vergleicht. Abhängig von dem Ergebnis dieses Vergleichs steuert die Prüfeinrichtung den mindestens einen Signalgeber an. Damit wird nicht nur der dem Steckerkontakt zugeordnete Dosenkontakt auf korrekten Anschluss an die Elektrik des LKW überprüft, sondern auch, ob die Elektrik des LKW an dem Dosenkontakt eine ausreichende Spannung bereitstellt, wie sie für den sicheren Betrieb eines über die Anhängersteckdose an den LKW anzuschließenden Anhängers benötigt wird.

Typischerweise liegt der Mindestwert, auf dessen Einhalten die Spannung überprüft wird, bei 5/6 der jeweiligen Nennspannung, d. h. bei 10 V bei einer Nennspannung von 12 V und bei 20 V bei einer Nennspannung von 24 V.

Das erfindungsgemäße Überprüfen der Spannung an den Steckerkontakt erfordert nicht, dass ein konkreter Spannungswert dieser Spannung gemessen wird. Die Spannung kann vielmehr direkt mit dem vorgegebenen Mindestwert verglichen werden. Der vorgegebene Mindestwert kann dabei zum Beispiel als Sperrspannung einer Z-Diode implementiert sein, so dass die Z-Diode leitend wird, wenn die vorgegebene Mindestspannung erreicht wird. Die jeweilige Spannung kann aber auch mit einem Komparator mit einer von der Prüfeinrichtung erzeugten Referenzspannung verglichen werden.

Der Benutzer der erfindungsgemäßen Prüfvorrichtung kann von dem mindestens einen Signalgeber genauer ablesen, wie es um die Elektrik des jeweiligen LKW steht, d. h. beispielsweise, ob der dem Steckerkontakt zugeordnete Dosenkontakt nur nicht genügend Spannung liefert oder auch grundsätzlich falsch kontaktiert ist.

Um über den mindestens einen Signalgeber verschiedene Informationen an den Benutzer der erfindungsgemäßen Prüfvorrichtung ausgeben zu können, ist der mindestens eine Signalgeber dazu ausgebildet, aktiv mindestens zwei verschiedene Signale auszugeben, und/oder er weist mindestens zwei verschiedene aktivierbare Signalisierungselemente auf. Bei den Signalisierungselementen kann es sich zum Beispiel um LED handeln. Auch mit nur einer LED können aktiv verschiedene Signale ausgegeben werden, beispielsweise indem die LED auf Dauerleuchten oder auf Blinken angesteuert wird. Mit zwei LED unterschiedlicher Farbe können sehr einfach verschiedene aktive Signale mit unterschiedlichem Bedeutungsinhalt ausgegeben werden. So kann eine grüne LED durch Leuchten einen ordnungsgemäßen Zustand der Elektrik des LKW anzeigen, während eine rote LED durch Leuten anzeigt, dass eine erfolgte Prüfung ein negatives Ergebnis in Bezug auf die Elektrik des LKW hatte.

Besonders bevorzugt ist es bei der erfindungsgemäßen Prüfvorrichtung, wenn der mindestens eine Signalgeber dem mindestens einen der Steckerkontakte exklusiv zugeordnet ist, so dass an dem mindestens einen Signalgeber das Prüfergebnis in Bezug auf den mindestens einen Steckerkontakt und den zugeordneten mindestens einen Dosenkontakt abgelesen werden kann.

Weiterhin ist es bei der erfindungsgemäßen Prüfvorrichtung bevorzugt, wenn nicht nur einer der Steckerkontakte sondern alle Steckerkontakte, die einem der Dosenkontakte für eine Versorgungsspannung zugeordnet sind, daraufhin überprüft werden, ob elektrische Spannungen gegenüber den zugehörigen Bezugspotentialen anliegen, die vorgegebene Mindestwerte für die jeweiligen Versorgungsspannungen erreichen oder nicht. Besonders bevorzugt ist es dabei, wenn die Prüfvorrichtung je Steuerkontakt, der einem der Dosenkontakte für eine Versorgungsspannung zugeordnet ist, einen dem jeweiligen Steckerkontakt exklusiv zugeordneten Signalgeber aufweist, den die Prüfeinrichtung abhängig davon ansteuert, ob die Spannung zwischen dem jeweiligen Steckerkontakt und dem zugehörigen Bezugspotential den zugehörigen vorgegebenen Mindestwert erreicht oder nicht.

Darüber hinaus steuert die Prüfeinrichtung der erfindungsgemäßen Prüfvorrichtung den mindestens einen Signalgeber abhängig davon an, ob über mindestens einen der Steckerkontakte, der einem der Dosenkontakte für eine elektrische Masse zugeordnet ist, beim Anlegen einer Prüfspannung ein Strom fließt oder nicht. Damit wird überprüft, ob der jeweilige Dosenkontakt korrekt angeschlossen ist. Speziell wird überprüft, ob beim Anlegen einer vorgegebenen Prüfspannung ein Strom fließt, der einen für den einen der Dosenkontakte vorgegebenen Strommindestwert erreicht, oder nicht. Damit wird nicht nur das Vorhandensein einer elektrischen Masse an dem jeweiligen Dosenkontakt sondern auch deren Funktion in Form ihres Innenwiderstands überprüft.

Vorzugsweise weist die erfindungsgemäße Prüfvorrichtung je Steckerkontakt, der einem der Dosenkontakte für eine elektrische Masse zugeordnet ist, einen dem jeweiligen Steckerkontakt exklusiv zugeordneten Signalgeber auf, den die Prüfeinrichtung abhängig davon ansteuert, ob beim Anlegen der zugehörigen vorgegebenen Prüfspannung ein Strom fließt, der einen für den jeweiligen Dosenkontakt vorgegebenen Strommindestwert erreicht, oder nicht.

Weiterhin kann die Prüfeinrichtung den mindestens einen Signalgeber abhängig davon ansteuern, ob an mindestens einem der Steckerkontakte, der einem der Dosenkontakte für eine Signalspannung zugeordnet ist, eine elektrische Spannung gegenüber dem zugehörigen Bezugspotential anliegt, die einen fehlerfreien Betriebszustand der Elektrik des LKW signalisiert. Bei diesem fehlerfreien Betriebszustand der Elektrik des LKW kann es sich um einen Grundzustand handeln, in dem die jeweilige Signalspannung weder einen Fehler der Elektrik des LKW signalisiert noch in irgendwelche Steuerbefehle übermittelt.

Vorzugsweise weist die Prüfvorrichtung je Steckerkontakt, der einem der Dosenkontakte für eine Signalspannung zugeordnet ist, einen dem jeweiligen Steckerkontakt exklusiv zugeordneten Signalgeber auf, den die Steuereinrichtung abhängig davon ansteuert, ob die jeweilige elektrische Spannung gegenüber dem zugehörigen Bezugspotential anliegt, die den fehlerfreien Betriebszustand der Elektrik des LKW signalisiert.

Insgesamt weist die erfindungsgemäße Prüfvorrichtung daher je Steckerkontakt und damit je mit Hilfe der Steckerkontakte überprüftem Dosenkontakt einen dem jeweiligen Steckerkontakt exklusiv zugeordneten Signalgeber auf, der anzeigt, ob der an dem zugehörigen Dosenkontakt angeschlossene Teil der Elektrik des LKW korrekt arbeitet.

Wenn der mindestens eine Signalgeber der erfindungsgemäßen Prüfvorrichtung in einem abgeflachten Bereich des im Querschnitt runden Gehäuses angeordnet ist, kann das Gehäuse mit seinem runden Querschnitt an den Anschlussquerschnitt des daran befestigten Steckers der Prüfvorrichtung angepasst sein. Die Anordnung des mindestens einen Signalgebers in dem abgeflachten Bereich vereinfacht die Lagerung des an den Signalgeber angeschlossenen Teils der Prüfeinrichtung, der üblicherweise auf einer ebenen Leiterplatte angeordnet ist, in dem Gehäuse.

Bei der erfindungsgemäßen Prüfvorrichtung ist vorteilhafterweise eine Legende zur Interpretation der Signale des mindestens einen Signalgebers direkt auf dem Gehäuse angeordnet, so dass ein Benutzer diese Signale beispielsweise auch dann ohne Nachschlagen in einer Bedienungsanleitung interpretieren kann, wenn ihm die Signale individuell zu jedem Steckerkontakt bzw. dem zugehörigen Dosenkontakt eine Information bereitstellen.

Die Prüfeinrichtung der erfindungsgemäßen Prüfvorrichtung kann einen Energiespeicher aufweisen, aus dem sie auch dann versorgt wird, wenn an den Steckerkontakten keine elektrischen Spannungen von extern anliegen. Vorzugsweise umfasst die Prüfeinrichtung jedoch eine Spannungsversorgung, die sich aus irgendeiner zwischen den Steckerkontakten anliegenden Spannung speist. Dabei kann die Spannungsversorgung so an die Steckerkontakte angeschlossen sein, dass jedwede dazwischen anliegende Spannung geeignet ist, die Spannungsversorgung zu speisen. Dies bedeutet, dass die zwischen den Steckerkontakten anliegende Spannung nicht einmal die richtige Polarität aufweisen muss, die sich ergibt, wenn die entsprechende Anhängersteckdose korrekt angeschlossen ist. Da es jedoch nur selten der Fall sein wird, dass keine der Versorgungsspannungen mit richtiger Polarität an den Steckerkontakten anliegt, kann es auch vorgesehen sein, die Spannungsversorgung alternativ aus allen Versorgungsspannungen zu speisen, die zwischen den Steckerkontakten anliegen sollten. Wenn dieses Versorgungsspannungen sämtlich nicht zur Verfügung stehen und der mindestens eine Signalgeber der erfindungsgemäßen Prüfvorrichtung entsprechend kein aktives Signal ausgeben kann, zeigt dies an, dass die Elektrik des jeweiligen LKW einen erheblichen Mangel in Bezug auf die Versorgungsspannungen aufweist, die an den entsprechenden Dosenkontakten seiner Anhängersteckdose anliegen sollten.

Konkret kann es sich bei dem Stecker der erfindungsgemäßen Prüfvorrichtung um einen Stecker nach der Norm ISO 7638 handeln. Die erfindungsgemäße Prüfvorrichtung ist dann entsprechend zur Überprüfung der Elektrik eines LKW über eine Anhängersteckdose dieser Norm ISO 7638 vorgesehen. Dabei kann es sich um eine Steckdose nach der Norm ISO 7638-1 für eine 24 Volt-Elektrik des LKW handeln, oder eine Steckdose nach der Norm ISO 7638-2 für eine 12 Volt-Elektrik des LKW. Es versteht sich, dass je nach der konkreten Norm die Mindestwerte, mit denen beispielsweise Versorgungsspannungen von der Prüfeinrichtung der erfindungsgemäßen Prüfvorrichtung verglichen werden, variieren. Beispielsweise wird bei einer 24 Volt-Elektrik des LKW jede Versorgungsspannung darauf zu überprüfen sein, ob sie einen Mindestwert von etwa 20 Volt, beispielsweise konkret 19 Volt, einhält.

Bei einer besonders bevorzugten Ausführungsform der erfindungsgemäßen Prüfvorrichtung sind die Steckerkontakte an Dosenkontakte einer Steckdose angeschlossen, die nach einer selben Norm wir der Stecker ausgebildet ist und die Teil der Prüfvorrichtung ist. Insbesondere kann die Steckdose an einem dem Stecker gegenüberliegenden Ende des Gehäuses befestigt sein. Die Prüfvorrichtung kann so auch zwischen den jeweiligen LKW und einen daran angeschlossenen Anhänger geschaltet werden, um die Elektrik des LKW auf unter Einfluss des Anhängers zu überprüfen.

Selbst wenn die erfindungsgemäße Prüfvorrichtung nur einen Stecker und keine eigene Steckdose aufweist, kann sie nicht nur zur direkten Überprüfung der Elektrik eines LKW an dessen Anhängersteckdose, sondern auch zum Überprüfen einer zwischen diese Anhängersteckdose und die Prüfvorrichtung geschalteten Anhängeranschlussleitung verwendet werden. Eine solche Anschlussleitung weist typischerweise ein Spiralkabel zwischen einem Leitungsstecker zum Einstecken in die Anhängersteckdose des LKW und einer Leitungssteckdose zum Verbinden mit einem Anhängerstecker an dem Anhänger auf und wird auch als SUSIE-Leitung bezeichnet.

Bei einer erfindungsgemäßen Verwendung der erfindungsgemäßen Prüfvorrichtung mit zusätzlicher Steckdose wird die Prüfvorrichtung mit ihrem Stecker zunächst in die Anhängersteckdose eines LKW eingesteckt, die Zündung des LKW eingeschaltet und dann der mindestens eine Signalgeber ausgelesen. Wenn dabei keine Signale registriert werden, die auf einen Fehler der Elektrik des LKW hinweisen, wird statt der erfindungsgemäßen Prüfvorrichtung ein Leitungsstecker eine Anhängeranschlussleitung in die Anhängersteckdose des LKW und die Prüfvorrichtung mit ihrem Stecker in eine Leitungssteckdose der Anhängeranschlussleitung eingesteckt, die Zündung des LKW eingeschaltet und dann der mindestens eine Signalgeber ausgelesen. Wenn auch dabei keine Signale registriert werden, die auf einen Fehler hinweisen, der dann bei der Anhängeranschlussleitung vorliegen würde, wird die Prüfvorrichtung mit der Anhängeranschlussleitung zwischen die Anhängersteckdose des LKW und einen Anhängerstecker eines Anhängers in Reihe geschaltet, eine Handbremse des LKW bei eingeschalteter Zündung betätigt und dann der mindestens eine Signalgeber ausgelesen. In diesem Fall überprüft die Prüfvorrichtung, soweit sie für eine Anhängersteckdose nach der Norm ISO 7638 ausgebildet ist, auch, ob ein ABS des Anhängers ordnungsgemäß funktioniert. Bei einer solchen Anhängersteckdose sind die Dosenkontakte für Signalspannungen solche eines sogenannten CAN-Busses. Dabei liegt, ohne dass der CAN-Bus Signale weiterleitet, die Signalspannung an einem der beiden entsprechenden Dosenkontakte auf einer unteren Spannung und der andere der beiden zugehörigen Dosenkontakte auf einer oberen Spannung, was die erfindungsgemäße Prüfvorrichtung durch den Vergleich mit entsprechenden oberen und/oder unteren Grenzwerten überprüft.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Die in den Patentansprüchen angeführten Merkmale können durch weitere Merkmale ergänzt werden oder die einzigen Merkmale sein, die das jeweilige Erzeugnis aufweist.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1**: zeigt eine erfindungsgemäße Prüfvorrichtung in einer Seitenansicht.
- **Fig. 2**: ist ein schematischer Schaltplan der erfindungsgemäßen Prüfvorrichtung gemäß Fig. 1.
- **Fig. 3**: ist ein Diagramm der von der Prüfvorrichtung gemäß Fig. 1 durgeführten Prüfungen; und
- **Fig. 4**: ist ein Flussdiagramm einer erfindungsgemäßen Verwendung der Prüfvorrichtung gemäß den Fig. 1 und 2.

### FIGURENBESCHREIBUNG

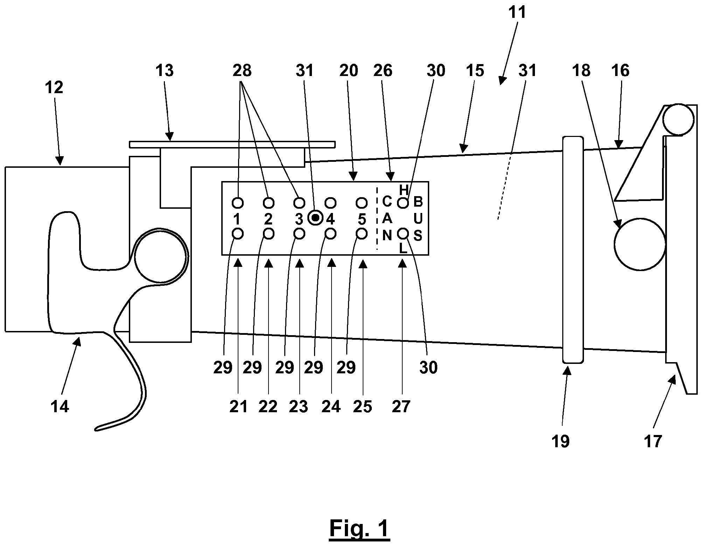

Die in **Fig. 1** dargestellte Prüfvorrichtung 11 weist einen Stecker 12 auf, der zum Einstecken in eine Anhängersteckdose gemäß der Norm ISO 7638 ausgebildet ist. Der Stecker 12 umfasst ein Klappenwiderlager 13 und ein schwenkbar gelagertes Verriegelungselement 14. Der Stecker 12 ist an einem Ende eines langgestreckten, leicht konusförmigen Gehäuses 15 mit im Wesentlichen rundem Querschnitt befestigt. An dem anderen Ende des Gehäuses 15 mit etwas größerem Durchmesser ist eine Steckdose 16 befestigt, die ebenfalls nach der Norm ISO 7638 ausgebildet ist. Sie weist eine Abdeckklappe 17 und zu dem verschwenkbaren Verriegelungselement 14 komplementäre Verriegelungselemente 18 auf. Zusätzlich ist hier eine Befestigungsplatte 19 Teil der Steckdose 16, die aber bei der Prüfvorrichtung 11 nicht genutzt ist. An dem Gehäuse 15 sind in einem abgeflachten Bereich 20 Signalgeber 21 bis 27 angeordnet. Dabei umfassen die Signalgeber 21 bis 25 jeweils eine grüne LED 28 und eine rote LED 29, während die Signalgeber 26 und 27 hier jeweils nur eine weiße LED 30 umfassen. Eine Leiterplatte, über die die LEDs 28 bis 30 elektrisch kontaktiert sind und angesteuert werden, ist auf der Rückseite des abgeflachten Bereichs 20 angeordnet und daran mit einer Befestigungsschraube 31 befestigt. In dem Inneren des Gehäuses 15 sind die Signalgeber 21 bis 27 an eine Prüfeinrichtung 32 angeschlossen, an die auch der Stecker 12 und die Steckdose 16 elektrisch angeschlossen sind.

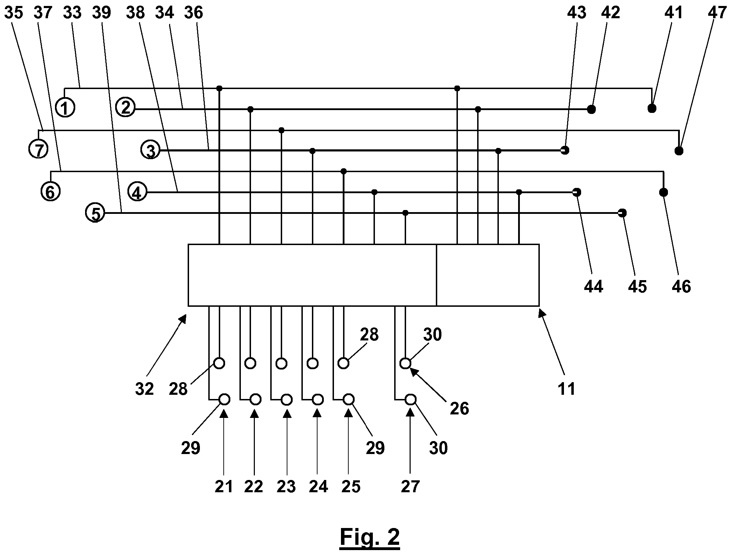

Der schematische Schaltplan der Prüfvorrichtung 11 gemäß Fig. 1, der in **Fig. 2** wiedergegeben ist, zeigt, dass jeweils einer von sieben Steckerkontakten 1 bis 7 des Steckers 12 über eine Verbindungsleitung 33 bis 39 direkt mit einem entsprechenden Dosenkontakt 41 bis 47 elektrisch kontaktiert ist. An jede der Verbindungsleitungen 33 bis 39 ist die Prüfeinrichtung 32 angeschlossen. Die Prüfeinrichtung 32 steuert die LEDs 28 bis 30 der Signalgeber 21 bis 27 an. Eine Spannungsversorgung 40 der Prüfeinrichtung 32 speist sich aus Spannungen zwischen den Verbindungsleitungen 33 und 34 einerseits und 35 und 36 andererseits. Dies berücksichtigt, dass bei einer Anhängersteckdose nach der Norm ISO 7638 an den den Steckerkontakten 1 und 2 entsprechenden Dosenkontakten Versorgungsspannungen gegenüber den den Steckerkontakten 4 und 3 entsprechenden Dosenkontakten anliegen. Dabei ist die Spannungsversorgung 40 vorzugsweise so ausgebildet, dass sie nicht darauf angewiesen ist, dass beide an den Dosenkontakten 1 und 2 anliegenden Versorgungsspannungen einen grundsätzlich vorgegebenen Mindestwert erreichen oder dass beide dieser Versorgungsspannungen überhaupt anliegen. So reicht auch nur eine einzige geringere Versorgungsspannung zum Speisen der Spannungsversorgung 40 aus.

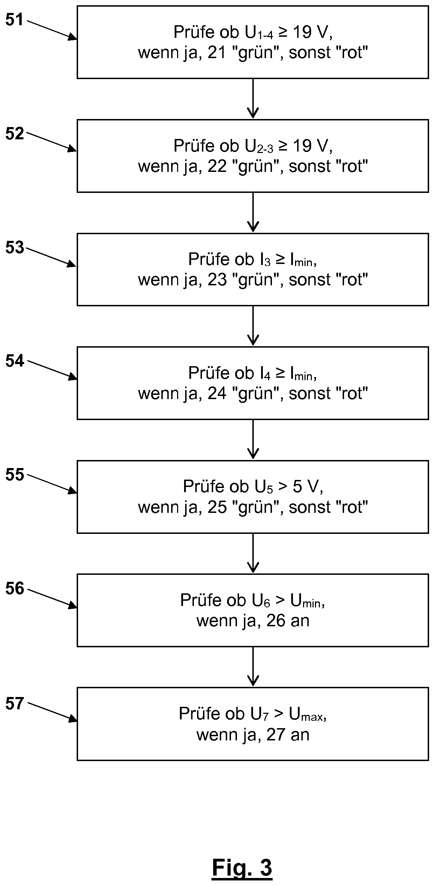

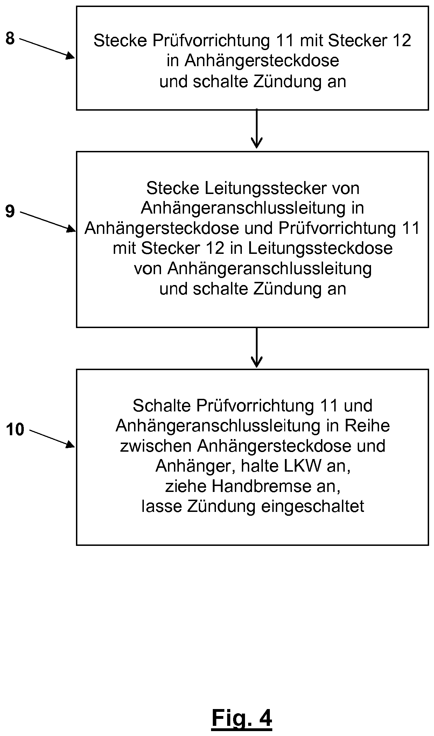

Die Prüfeinrichtung 32 führt verschiedene Prüfungen durch, wie sie im Folgenden anhand von **Fig. 3** näher erläutert werden. Dabei können diese Prüfungen sowohl durchgeführt werden, wenn die Prüfvorrichtung 11 nur mit ihrem Stecker 12 in eine Anhängersteckdose oder eine Leitungssteckdose einer zu einer Anhängersteckdose führenden Anhängeranschlussleitung eingesteckt ist, aber auch wenn die Prüfvorrichtung mit einer solchen Anhängeranschlussleitung in Reihe zwischen eine Anhängersteckdose und einen Anhänger eines LKW geschaltet ist. Im letzteren Fall prüft die Prüfeinrichtung 32 nicht nur die Elektrik des LKW bzw. die Elektrik des LKW und die Anhängeranschlussleitung, sondern auch die Elektrik des Anhängers. Hierauf wird im Zusammenhang mit der folgenden Fig. 4 noch näher eingegangen werden. Die in Fig. 3 in einer bestimmten Reihenfolge dargestellten Prüfungen 51 bis 57 können von der Prüfeinrichtung 32 auch in jeder anderen Reihenfolge oder auch ganz oder teilweise parallel durchgeführt werden. Bei der Prüfung 51 prüft die Prüfeinrichtung 32, ob eine Spannung U₁₋₄, die an dem Steckerkontakt 1 gegenüber dem Steckerkontakt 4 anliegt, einen Mindestwert von hier 19 Volt erreicht. Falls dies der Fall ist, lässt die Prüfeinrichtung 32 die grüne LED 28 des Signalgebers 21 leuchten, sonst seine rote LED 29. Entsprechend prüft die Prüfeinrichtung 32 bei der Prüfung 52, ob eine Spannung U₂₋₃ an dem Steckerkontakt 2 gegenüber dem Steckerkontakt 3 mindestens 19 Volt erreicht. Falls dies der Fall ist, lässt die Prüfeinrichtung 32 die grüne LED 28 des Signalgebers 22 leuchten, sonst seine rote LED 29. Bei der Prüfung 53 prüft die Prüfeinrichtung 32, ob ein infolge der Spannung U₂₋₃ über den Steckerkontakt 3 fließender Strom einen Strommindestwert Iₘᵢₙ erreicht. Falls dies der Fall ist, lässt die Prüfeinrichtung 32 die grüne LED 28 des Signalgebers 23 leuchten, sonst seine rote LED 29. Entsprechend prüft die Prüfeinrichtung 32 bei der Prüfung 54, ob ein von der Spannung U₁₋₄ über den Steckerkontakt 4 getriebener Strom I₄ den Strommindestwert Iₘᵢₙ erreicht. Falls dies der Fall ist, lässt sie die grüne LED 28 des Signalgebers 24 leuchten, sonst seine rote LED 29. In einer Prüfung 55 prüft die Prüfeinrichtung 32, ob eine Spannung U₅ an dem Steckerkontakt 5 eindeutig über 5 Volt liegt, weil eine darunter liegende Spannung nach der Norm ISO 7638 an dem Steckerkontakt 5 einen ABS-Fehler signalisiert. Wenn die Spannung 5 Volt übersteigt, lässt die Prüfeinrichtung 32 den Signalgeber 25 durch Ansteuern seiner LED 28 grün leuchten, sonst durch Ansteuern seiner LED 29 rot. Bei der Prüfung 56 prüft die Prüfeinrichtung 32, ob eine Spannung U₆ an dem Steckerkontakt 6 größer als eine Mindestspannung Uₘᵢₙ ist. Wenn dies der Fall ist, lässt die die LED 30 des Signalgebers 26 leuchten, die anzeigt, dass eine obere Signalspannung eines CAN-Busses ihren Sollwert erreicht. Bei der Prüfung 57 prüft die Prüfeinrichtung 32, ob eine Spannung U₇ an dem Steckerkontakt 7 anliegt, aber kleiner als Uₘₐₓ bleibt. Wenn dies der Fall ist, lässt sie die LED 30 des Signalgebers 27 leuchten. Dies zeigt an, dass die untere Signalspannung des CAN-Busses vorhanden ist und das richtige Spannungsniveau aufweist. Die Spannungen U₅ bis U₇ ermittelt die Prüfeinrichtung 32 gegenüber einem Bezugspotential, das durch den Steckerkontakt 3 und/oder den Steckerkontakt 4 vorgegeben wird, je nachdem, welcher der beiden Steckerkontakte 3 und 4 mit einer funktionsfähigen Masse verbunden ist, was durch die Prüfungen 53 und 54 ermittelt wird.

Die Prüfungen 51 bis 57 werden mit der erfindungsgemäßen Prüfvorrichtung 11 vorzugsweise dreimal unter jeweils unterschiedlichen Bedingungen durchgeführt. **Fig. 4** illustriert, dass sich diese Bedingungen in einem ersten Schritt 8 dadurch ergeben, dass die Prüfvorrichtung 11 mit ihrem Stecker 12 in eine Anhängersteckdose eines LKW eingesteckt und die Zündung des LKW eingeschaltet wird. In einem folgenden Schritt 9 ergeben sich die Bedingungen dadurch, dass statt der Prüfvorrichtung ein Leitungsstecker einer Anhängeranschlussleitung in die Anhängersteckdose eingesteckt wird und die Prüfvorrichtung 11 mit ihrem Stecker 12 in eine Leitungssteckdose der Anhängeranschlussleitung und dass dann die Zündung des LKW eingeschaltet wird. Dadurch wird zusätzlich die Anhängeranschlussleitung mit der Prüfvorrichtung 11 überprüft. In einem dritten und letzten Schritt 10 wird die Prüfvorrichtung 11 mit der Anhängeranschlussleitung in Reihe zwischen die Anhängersteckdose und einen Anhänger des jeweiligen LKW geschaltet. Dabei ist es unerheblich, in welcher Reihenfolge die bereits geprüfte Anhängeranschlussleitung mit der Prüfvorrichtung in Reihe geschaltet wird. Dann wird der LKW gefahren, angehalten, seine Handbremse gezogen und seine Zündung eingeschaltet gelassen, bis die Prüfungen 51 bis 57 zum dritten Mal durchgeführt und das durch die Signalgeber 21 bis 27 angezeigte Prüfungsergebnis ausgelesen wird. In den Schritten 8 bis 10 von der Prüfvorrichtung aufgezeigte Fehler der Elektrik des LKW sind sofort zu beseitigen. Bei einem LKW mit ordnungsgemäßer Elektrik, einschließlich ordnungsgemäßem Anschluss seiner Anhängersteckdose und ordnungsgemäßer Elektrik seines Anhängers leuchten immer alle grünen LEDs 28 der Signalgeber 21 bis 25 und beide weiße LEDs 30 der Signalgeber 26 und 27.

### BEZUGSZEICHENLISTE

- 1: Steckerkontakt
- 2: Steckerkontakt
- 3: Steckerkontakt
- 4: Steckerkontakt
- 5: Steckerkontakt
- 6: Steckerkontakt
- 7: Steckerkontakt
- 8: Schritt
- 9: Schritt
- 10: Schritt
- 11: Prüfvorrichtung
- 12: Stecker
- 13: Klappenwiderlager
- 14: Verriegelungselement
- 15: Gehäuse
- 16: Steckdose
- 17: Abdeckklappe
- 18: Verriegelungselement
- 19: Befestigungsplatte
- 20: abgeflachter Bereich
- 21: Signalgeber
- 22: Signalgeber
- 23: Signalgeber
- 24: Signalgeber
- 25: Signalgeber
- 26: Signalgeber
- 27: Signalgeber
- 28: grüne LED
- 29: rote LED
- 30: weiße LED
- 31: Befestigungsschraube
- 32: Prüfeinrichtung
- 33: Verbindungsleitung
- 34: Verbindungsleitung
- 35: Verbindungsleitung
- 36: Verbindungsleitung
- 37: Verbindungsleitung
- 38: Verbindungsleitung
- 39: Verbindungsleitung
- 40: Spannungsversorgung
- 41: Dosenkontakt
- 42: Dosenkontakt
- 43: Dosenkontakt
- 44: Dosenkontakt
- 45: Dosenkontakt
- 46: Dosenkontakt
- 47: Dosenkontakt
- 51: Prüfung
- 52: Prüfung
- 53: Prüfung
- 54: Prüfung
- 55: Prüfung
- 56: Prüfung
- 57: Prüfung

## Patentansprüche

1. Prüfvorrichtung (11) für die Elektrik eines LKW mit
- einem Stecker (12) zum Einstecken in eine Anhängersteckdose des LKW, der Steckerkontakte (1 bis 7) zum Kontaktieren von Dosenkontakten der Anhängersteckdose umfasst,
- einem Gehäuse (15), an dem der Stecker (12) befestigt ist, in dem eine Prüfeinrichtung (32) gelagert ist und an dem mindestens ein optischer Signalgeber (21 bis 27) angeordnet ist,
- wobei die Prüfeinrichtung (32) an die Steckerkontakte (1 bis 7) und den mindestens einen Signalgeber (21 bis 27) angeschlossen ist und den mindestens einen Signalgeber (21 bis 27) in Abhängigkeit von elektrischen Spannungen zwischen den Steckerkontakten (1 bis 7) ansteuert,
- wobei die Prüfeinrichtung (32) den mindestens einen Signalgeber (21 bis 27) sowohl abhängig davon ansteuert, ob an mindestens einem der Steckerkontakte (1 bis 7) irgendeine elektrische Spannung gegenüber einem Bezugspotential, die das richtige Vorzeichen aufweist, anliegt oder nicht, als auch abhängig davon, ob die Spannung zwischen dem mindestens einen der Steckerkontakte (1 bis 7) und dem Bezugspotential einen vorgegebenen Mindestwert erreicht oder nicht,
**dadurch gekennzeichnet,**
- **dass** der Mindestwert der elektrischen Spannung so vorgegeben ist, wie er für den sicheren Betrieb eines über die Anhängersteckdose an den LKW anzuschließenden Anhängers benötigt wird, und
- **dass** von dem mindestens einen Signalgeber (21 bis 27) ablesbar ist, ob der dem Steckerkontakt (1 bis 7) zugeordnete Dosenkontakt nur nicht genügend Spannung liefert oder auch grundsätzlich falsch kontaktiert ist, wobei der mindestens eine Signalgeber (21 bis 27) dazu ausgebildet ist, aktiv mindestens zwei verschiedene Signale auszugeben, und/oder mindestens zwei verschiedene aktivierbare Signalisierelemente aufweist, und
- **dass** die Prüfeinrichtung (32) den mindestens einen Signalgeber (21 bis 27) abhängig davon ansteuert, ob über mindestens einen der Steckerkontakte (1 bis 7), der einem der Dosenkontakte für eine elektrische Masse zugeordnet ist, beim Anlegen einer vorgegebenen Prüfspannung ein Strom fließt, der einen für den einen der Dosenkontakte vorgegebenen Strommindestwert erreicht, oder nicht.

2. Prüfvorrichtung (11) nach Anspruch 1, **dadurch gekennzeichnet, dass** der mindestens eine Signalgeber (21 bis 27) dem mindestens einen der Steckerkontakte (1 bis 7) exklusiv zugeordnet ist.

3. Prüfvorrichtung (11) nach einem der vorhergehenden Ansprüche, **dadurch gekennzeichnet, dass** die Prüfeinrichtung (32) den mindestens einen Signalgeber (21 bis 27) abhängig davon ansteuert, ob an jedem der Steckerkontakte (1 bis 7), der einem der Dosenkontakte für eine Versorgungsspannung zugeordnet ist, eine elektrische Spannung gegenüber dem zugehörigen Bezugspotential anliegt, die den vorgegebenen Mindestwert für die jeweilige Versorgungsspannung erreicht, oder nicht.

4. Prüfvorrichtung (11) nach Anspruch 3, **dadurch gekennzeichnet, dass** die Prüfvorrichtung je Steckerkontakt (1 bis 7), der einem der Dosenkontakte für eine Versorgungsspannung zugeordnet ist, einen dem jeweiligen Steckerkontakt (1 bis 7) exklusiv zugeordneten Signalgeber (21 bis 27) aufweist, den die Prüfeinrichtung (32) abhängig davon ansteuert, ob die Spannung zwischen dem jeweiligen Steckerkontakt (1 bis 7) und dem zugehörigen Bezugspotential den zugehörigen vorgegebenen Mindestwert erreicht oder nicht.

5. Prüfvorrichtung (11) nach einem der vorhergehenden Ansprüche, **dadurch gekennzeichnet, dass** die Prüfvorrichtung (11) je Steckerkontakt (1 bis 7), der einem der Dosenkontakte für eine elektrische Masse zugeordnet ist, einen dem jeweiligen Steckerkontakt (1 bis 7) exklusiv zugeordneten Signalgeber (21 bis 27) aufweist, den die Prüfeinrichtung (32) abhängig davon ansteuert, ob beim Anlegen der zugehörigen vorgegebenen Prüfspannung ein Strom fließt, der einen für den jeweiligen Dosenkontakt vorgegebenen Strommindestwert erreicht, oder nicht.

6. Prüfvorrichtung (11) nach einem der vorhergehenden Ansprüche, **dadurch gekennzeichnet, dass** die Prüfeinrichtung (32) den mindestens einen Signalgeber (21 bis 27) abhängig davon ansteuert, ob an mindestens einem der Steckerkontakte (1 bis 7), der einem der Dosenkontakte für eine Signalspannung zugeordnet ist, eine elektrische Spannung gegenüber dem zugehörigen Bezugspotential anliegt, die einen fehlerfreien Betriebszustand der Elektrik des LKW signalisiert.

7. Prüfvorrichtung (11) nach Anspruch 6, **dadurch gekennzeichnet, dass** die Prüfvorrichtung (11) je Steckerkontakt (1 bis 7), der einem der Dosenkontakte für eine Signalspannung zugeordnet ist, einen dem jeweiligen Steckerkontakt (1 bis 7) exklusiv zugeordneten Signalgeber (21 bis 27) aufweist, den die Prüfeinrichtung (32) abhängig davon ansteuert, ob die jeweilige elektrische Spannung gegenüber dem zugehörigen Bezugspotential anliegt, die den fehlerfreien Betriebszustand der Elektrik des LKW signalisiert.

8. Prüfvorrichtung (11) nach einem der vorhergehenden Ansprüche, **dadurch gekennzeichnet, dass** der mindestens eine Signalgeber (21 bis 27) in einem abgeflachten Bereich (20) des im Querschnitt runden Gehäuses (15) angeordnet ist.

9. Prüfvorrichtung (11) nach einem der vorhergehenden Ansprüche, **dadurch gekennzeichnet, dass** eine Legende zur Interpretation von Signalen des mindestens einen Signalgebers (21 bis 27) auf dem Gehäuse (15) angeordnet ist.

10. Prüfvorrichtung (11) nach einem der vorhergehenden Ansprüche, **dadurch gekennzeichnet, dass** die Prüfeinrichtung (32) eine Spannungsversorgung (40) umfasst, die sich aus irgendeiner zwischen den Steckerkontakten (1 bis 7) anliegenden Spannung speist.

11. Prüfvorrichtung (11) nach einem der vorhergehenden Ansprüche, **dadurch gekennzeichnet, dass** an die Steckerkontakte (1 bis 7) Dosenkontakte einer Steckdose (16) angeschlossen sind, die nach einer selben Norm wie der Stecker (12) ausgebildet ist und die Teil der Prüfvorrichtung (11) ist.

12. Prüfvorrichtung (11) nach Anspruch 11, **dadurch gekennzeichnet, dass** die Steckdose (16) an einem dem Stecker (12) gegenüberliegenden Ende des Gehäuses (15) befestigt ist.

13. Verwendung einer Prüfvorrichtung (11) nach Anspruch 11 oder 12, **dadurch gekennzeichnet,**
- **dass** die Prüfvorrichtung (11) mit ihrem Stecker (12) in die Anhängersteckdose eines LKW eingesteckt, die Zündung des LKW eingeschaltet und dann der mindestens eine Signalgeber (21 bis 27) ausgelesen werden wird,
- **dass** ein Leitungsstecker einer Anhängeranschlussleitung in die Anhängersteckdose des LKW und die Prüfvorrichtung (11) mit ihrem Stecker (12) in eine Leitungssteckdose der Anhängeranschlussleitung eingesteckt, die Zündung des LKW eingeschaltet und dann der mindestens eine Signalgeber (21 bis 27) ausgelesen wird und
- **dass** die Prüfvorrichtung (11) mit der Anhängeranschlussleitung zwischen die Anhängersteckdose des LKW und einen Anhängerstecker eines Anhängers in Reihe geschaltet, eine Handbremse des LKW bei eingeschalteter Zündung betätigt und dann der mindestens eine Signalgeber (21 bis 27) ausgelesen wird.

## Claims

1. Testing apparatus (11) for the electrical system of a truck, comprising
- a plug (12) for insertion into a trailer socket of the truck, which comprises plug contacts (1 to 7) for contacting socket contacts of the trailer socket,
- a housing (15) to which the plug (12) is attached, in which a testing device (32) is mounted and on which at least one optical signal transmitter (21 to 27) is arranged,
- wherein the testing device (32) is connected to the plug contacts (1 to 7) and the at least one signal transmitter (21 to 27) and actuates the at least one signal transmitter (21 to 27) as a function of electrical voltages between the plug contacts (1 to 7),
- wherein the testing device (32) activates the at least one signal transmitter (21 to 27) both as a function of whether or not any electrical voltage with respect to a reference potential, which has the correct sign, is present at at least one of the plug contacts (1 to 7), and as a function of whether or not the voltage between the at least one of the plug contacts (1 to 7) and the reference potential reaches a predetermined minimum value,
**characterized in**
- **that** the minimum value of the electrical voltage is specified as required for the safe operation of a trailer to be connected to the truck via the trailer socket, and
- **that** it can be read from the at least one signal transmitter (21 to 27) whether the socket contact assigned to the plug contact (1 to 7) is just not supplying sufficient voltage or is even basically incorrectly contacted, wherein the at least one signal transmitter (21 to 27) is designed to actively output at least two different signals and/or has at least two different signaling elements which can be activated, and
- **that** the testing device (32) activates the at least one signal transmitter (21 to 27) as a function of whether or not a current flows via at least one of the plug contacts (1 to 7), which is assigned to one of the socket contacts for an electrical earth, when a predetermined test voltage is applied, which current reaches a predetermined minimum current value for the one of the socket contacts.

2. Testing apparatus (11) according to claim 1, **characterized in that** the at least one signal transmitter (21 to 27) is exclusively assigned to the at least one of the plug contacts (1 to 7).

3. Testing apparatus (11) according to one of the preceding claims, **characterized in that** the testing device (32) activates the at least one signal transmitter (21 to 27) as a function of whether or not an electrical voltage with respect to the associated reference potential is present at each of the plug contacts (1 to 7), which is assigned to one of the socket contacts for a supply voltage, which voltage reaches the predetermined minimum value for the respective supply voltage.

4. Testing apparatus (11) according to claim 3, **characterized in that** the testing apparatus has, for each plug contact (1 to 7) which is assigned to one of the socket contacts for a supply voltage, one signal transmitter (21 to 27) which is exclusively assigned to the respective plug contact (1 to 7) and which the testing device (32) activates as a function of whether or not the voltage between the respective plug contact (1 to 7) and the associated reference potential reaches the associated predetermined minimum value.

5. Testing apparatus (11) according to any of the preceding claims, **characterized in that** the testing apparatus (11) has, for each plug contact (1 to 7) which is assigned to one of the socket contacts for an electrical earth, one signal transmitter (21 to 27) which is exclusively assigned to the respective plug contact (1 to 7) and which the testing device (32) activates as a function of whether or not a current flows, which reaches a minimum current value predetermined for the respective socket contact, when the associated predetermined test voltage is applied.

6. Testing apparatus (11) according to any of the preceding claims, **characterized in that** the testing device (32) activates the at least one signal transmitter (21 to 27) as a function of whether an electrical voltage with respect to the associated reference potential, which signals a fault-free operating state of the electrical system of the truck, is present at at least one of the plug contacts (1 to 7), which is assigned to one of the socket contacts for a signal voltage.

7. Testing apparatus (11) according to claim 6, **characterized in that** the testing apparatus (11) has, for each plug contact (1 to 7) which is assigned to one of the socket contacts for a signal voltage, one signal transmitter (21 to 27) which is exclusively assigned to the respective plug contact (1 to 7) and which the testing device (32) activates as a function of whether the respective electrical voltage with respect to the associated reference potential is present, which signals the fault-free operating state of the electrical system of the truck.

8. Testing apparatus (11) according to any of the preceding claims, **characterized in that** the at least one signal transmitter (21 to 27) is arranged in a flattened region (20) of the housing (15), which is round in cross-section.

9. Testing apparatus (11) according to any of the preceding claims, **characterized in that** a legend for interpreting signals of the at least one signal transmitter (21 to 27) is arranged on the housing (15).

10. Testing apparatus (11) according to any of the preceding claims, **characterized in that** the testing device (32) comprises a voltage supply (40) which is fed from any voltage applied between the plug contacts (1 to 7)

11. Testing apparatus (11) according to any of the preceding claims, **characterized in that** socket contacts of a socket (16) are connected to the plug contacts (1 to 7), which socket is designed according to the same standard as the plug (12) and which socket is part of the testing apparatus (11).

12. Testing apparatus (11) according to claim 11, **characterized in that** the socket (16) is attached to an end of the housing (15) opposite the plug (12).

13. Use of a testing apparatus (11) according to claim 11 or 12, **characterized in**
- **that** the testing apparatus (11) is plugged with its plug (12) into the trailer socket of a truck, the ignition of the truck is switched on and then the at least one signal transmitter (21 to 27) is read out,
- **that** a cable plug of a trailer connecting cable is plugged into the trailer socket of the truck and the testing apparatus (11) is plugged with its plug (12) into a cable socket of the trailer connecting cable, the ignition of the truck is switched on and then the at least one signal transmitter (21 to 27) is read out, and
- **that** the testing apparatus (11) is connected in series with the trailer connection cable between the trailer socket of the truck and a trailer socket of a trailer, a handbrake of the truck is actuated with the ignition switched on and then the at least one signal transmitter (21 to 27) is read out.

## Revendications

1. Dispositif de contrôle (11) pour le système électrique d'un camion avec
- une fiche mâle (12) à enficher dans une prise de remorque du camion, qui comprend des contacts de fiche mâle (1 à 7) pour la mise en contact avec les contacts de prise femelle de la prise de remorque,
- un boîtier (15) sur lequel est fixée la fiche mâle (12), dans lequel est logé un dispositif de contrôle (32) et sur lequel est agencé au moins un générateur de signaux optiques (21 à 27),
- le dispositif de contrôle (32) étant raccordé aux contacts de fiche mâle (1 à 7) et à l'au moins un générateur de signaux (21 à 27) et commandant l'au moins un générateur de signaux (21 à 27) en fonction des tensions électriques entre les contacts de fiche mâle (1 à 7),
- le dispositif de contrôle (32) commandant l'au moins un générateur de signaux (21 à 27) à la fois en fonction de la présence ou de l'absence d'une tension électrique quelconque, qui présente le signe correct, à au moins un des contacts de fiche mâle (1 à 7) par rapport à un potentiel de référence, et en fonction du fait que la tension entre l'au moins un des contacts de fiche mâle (1 à 7) et le potentiel de référence atteigne ou non une valeur minimale prédéfinie,
**caractérisé en ce que**
- la valeur minimale de la tension électrique est fixée au niveau requis pour le fonctionnement sûr d'une remorque devant être raccordée au camion par la prise de remorque et
- **en ce que** l'au moins un générateur de signaux (21 à 27) permet de lire si le contact de prise associé au contact de fiche mâle (1 à 7) ne fournit pas seulement une tension suffisante ou est aussi en principe mal mis en contact, l'au moins un générateur de signaux (21 à 27) étant conçu pour émettre activement au moins deux signaux différents et/ou présentant au moins deux éléments de signalisation différents activables, et
- **en ce que** le dispositif de contrôle (32) commande l'au moins un générateur de signaux (21 à 27) en fonction du fait qu'un courant passe ou non par au moins l'un des contacts de fiche mâle (1 à 7), qui est attribué à l'un des contacts de prise femelle pour une masse électrique, lors de l'application d'une tension de contrôle prédéfinie, courant qui atteint ou non une valeur minimale de courant prédéfinie pour l'un des contacts de prise femelle.

2. Dispositif de contrôle (11) selon la revendication 1, **caractérisé en ce que** l'au moins un générateur de signaux (21 à 27) est attribué de manière exclusive à l'au moins un des contacts de fiche mâle (1 à 7).

3. Dispositif de contrôle (11) selon l'une des revendications précédentes, **caractérisé en ce que** le dispositif de contrôle (32) commande l'au moins un générateur de signaux (21 à 27) en fonction du fait que, sur chacun des contacts de fiche mâle (1 à 7) attribués à l'un des contacts de prise femelle pour une tension d'alimentation, une tension électrique soit présente ou absente par rapport au potentiel de référence associé qui atteint ou non la valeur minimale prédéterminée pour la tension d'alimentation correspondante.

4. Dispositif de contrôle (11) selon la revendication 3, **caractérisé en ce que** le dispositif de contrôle présente, pour chaque contact de fiche mâle (1 à 7) qui est attribué à l'un des contacts de prise femelle pour une tension d'alimentation, un générateur de signaux (21 à 27) attribué exclusivement au contact de fiche mâle correspondant (1 à 7), que le dispositif de contrôle (32) commande en fonction du fait que la tension entre le contact de fiche mâle correspondant (1 à 7) et le potentiel de référence associé atteigne ou non la valeur minimale prédéfinie associée.

5. Dispositif de contrôle (11) selon l'une des revendications précédentes, **caractérisé en ce que** le dispositif de contrôle (11) présente, pour chaque contact de fiche mâle (1 à 7) qui est attribué à l'un des contacts de prise femelle pour une masse électrique, un générateur de signaux (21 à 27) attribué exclusivement au contact de fiche mâle (1 à 7) correspondant, que le dispositif de contrôle (32) commande en fonction du fait que, lors de l'application de la tension de contrôle prédéfinie associée, le courant qui circule atteigne ou non une valeur minimale de courant prédéfinie pour le contact de prise femelle correspondant.

6. Dispositif de contrôle (11) selon l'une des revendications précédentes, **caractérisé en ce que** le dispositif de contrôle (32) commande l'au moins un générateur de signaux (21 à 27) en fonction du fait que, sur au moins l'un des contacts de fiche mâle (1 à 7) attribués à l'un des contacts de prise femelle pour une tension de signal, une tension électrique qui signale un état de fonctionnement sans défaut du système électrique du camion soit présente ou non par rapport au potentiel de référence associé.

7. Dispositif de contrôle (11) selon la revendication 6, **caractérisé en ce que** le dispositif de contrôle (11) présente, pour chaque contact de fiche mâle (1 à 7) qui est attribué à l'un des contacts de prise femelle pour une tension de signal, un générateur de signaux (21 à 27) associé exclusivement au contact de fiche mâle (1 à 7), que le dispositif de contrôle (32) commande en fonction du fait que la tension électrique respective qui signale un état de fonctionnement sans défaut du système électrique du camion soit présente ou non par rapport au potentiel de référence associé.

8. Dispositif de contrôle (11) selon l'une des revendications précédentes, **caractérisé en ce que** l'au moins un générateur de signaux (21 à 27) est agencé dans une zone aplatie (20) du boîtier (15) de section transversale ronde.

9. Dispositif de contrôle (11) selon l'une des revendications précédentes, **caractérisé en ce qu'**une légende pour l'interprétation des signaux de l'au moins un générateur de signaux (21 à 27) est agencée sur le boîtier (15).

10. Dispositif de contrôle (11) selon l'une quelconque des revendications précédentes, **caractérisé en ce que** le dispositif de contrôle (32) comprend une alimentation électrique (40) qui se nourrit d'une tension quelconque appliquée entre les contacts de fiche mâle (1 à 7).

11. Dispositif de contrôle (11) selon l'une quelconque des revendications précédentes, **caractérisé en ce que** les contacts de prise femelle d'une prise mâle (16) qui est réalisée selon une même norme que la fiche mâle (12) et qui fait partie du dispositif de contrôle (11) sont raccordés à des contacts de fiche mâle (1 à 7).

12. Dispositif de contrôle (11) selon la revendication 11, **caractérisé en ce que** la prise mâle (16) est fixée à une extrémité du boîtier (15) opposée à la fiche mâle (12).

13. Utilisation d'un dispositif de contrôle (11) selon la revendication 11 ou 12, **caractérisé en ce que**
- le dispositif de contrôle (11) est enfiché à sa fiche mâle (12) dans la prise de remorque d'un camion, que l'allumage du camion est enclenché et qu'ensuite l'au moins un générateur de signaux (21 à 27) est lu,
- **en ce qu'**une fiche de câble d'un câble de raccordement de remorque est introduite dans la prise de remorque du camion et le dispositif de contrôle (11) est introduit avec sa fiche mâle (12) dans une prise de connecteur de raccordement de remorque, que l'allumage du camion est enclenché et qu'ensuite l'au moins un générateur de signaux (21 à 27) est lu et
- **en ce que** le dispositif de contrôle (11) est branché en série avec la ligne de raccordement de remorque entre la prise de remorque du camion et une fiche de remorque d'une remorque, qu'un frein à main du camion est actionné lorsque l'allumage est enclenché et qu'ensuite l'au moins un générateur de signaux (21 à 27) est lu.
